# EUROPÄISCHE PATENTANMELDUNG

(11) **EP 3 316 666 A1**
(43) Veröffentlichungstag der Anmeldung: **02.05.2018**
(21) Anmeldenummer: 17190527.6
(22) Anmeldetag: 12.09.2017
(51) Int. Cl.: H05K 1/02, H04B 15/02, H05K 9/00, H05K 3/32, H05K 3/34, H05K 3/12

(54) **VERFAHREN ZUR HERSTELLUNG EINES ELEKTRONISCHEN BAUELEMENTS UND ELEKTRONISCHES BAUELEMENT**

(30) Priorität: 25.10.2016 DE 102016220929
(71) Anmelder: Robert Bosch GmbH, 70442 Stuttgart (DE)
(72) Erfinder: Watermann, Fred, 31141 Hildesheim (DE)

(57) **Zusammenfassung**

Gegenstand der Erfindung ist ein Verfahren zur Herstellung eines elektronischen Bauelements (100), bei welchem eine Leiterplatte (12) zwischen einem ersten Gehäuseteil (10) und einem zweiten Gehäuseteil (11) positioniert wird und die beiden Gehäuseteile (10, 11) an mehreren Befestigungsstellen (15) kraftschlüssig miteinander verbunden werden, wobei zwischen den Befestigungsstellen (15) auf der Leiterplatte (12) eine Vielzahl von Auftragsflächen (14) ausgebildet sind, auf welchen jeweils ein Lotwerkstoff (18) derart aufgebracht wird, dass der Lotwerkstoff (18) die Auftragsfläche (14) jeweils überlappt, wobei nach dem Aufbringen des Lotwerkstoffs (18) Wärme zugeführt wird, wodurch sich der Lotwerkstoff (18) auf der Auftragsfläche (14) zusammenzieht und eine kuppelartige Ausbildung auf der Auftragsfläche (14) ausbildet, wobei die Höhe (h₁, h₂) der kuppelartigen Ausbildung jeweils derart angepasst ist, dass der Lotwerkstoff (18) einen Kontaktpunkt mit einem der beiden Gehäuseteile (10, 11) ausbildet.

## Beschreibung

Die Erfindung betrifft ein Verfahren zur Herstellung eines elektronischen Bauelements. Ferner betrifft die Erfindung ein elektronisches Bauelement.

### Stand der Technik

Bei elektronischen Bauelementen, wie beispielsweise einem Navigationsgerät oder einem Radio, besteht häufig die Anforderung, dass diese eine elektromagnetische Verträglichkeit, auch EMV genannt, aufweisen, was bedeutet, dass die Bauelemente andere Bauelemente nicht durch elektrische oder elektromagnetische Effekte beeinflussen sollen und auch nicht selbst beeinflusst werden sollen. Um dies gewährleisten zu können, ist eine sichere elektrische Anbindung der in einem Bauelement angeordneten Leiterplatte mit den die Leiterplatte umgebenden Gehäuseteilen über den gesamten oder zumindest einen Großteil des Randbereichs der Leiterplatte bzw. der Gehäuseteile notwendig, so dass die elektrische Anbindung eine möglichst effektive elektromagnetische Abschirmung bewirken kann.

### Offenbarung der Erfindung

Vor diesem Hintergrund werden mit der vorliegenden Erfindung ein Verfahren gemäß Anspruch 1 und ein elektronisches Bauelement gemäß Anspruch 8 vorgestellt. Zweckmäßige Ausgestaltungen und vorteilhafte Weiterbildungen der Erfindung sind in den Unteransprüchen angegeben.

Unter elektronischen Bauelementen werden im Zusammenhang mit der vorliegenden Erfindung elektronische Geräte, wie insbesondere beispielsweise Fahrzeug-Navigationsgeräte, Rundfunkempfangsgeräte, Steuergeräte oder andere Geräte verstanden, die typischerweise in Fahrzeugen, insbesondere Kraftfahrzeugen installiert und betrieben werden können. Bauelemente können aber auch anderweitige, insbesondere für einen mobilen Einsatz vorgesehene elektronische Geräte, wie Mobiltelefone oder andere mobile Kommunikationgeräte, tragbare Navigationsgeräte oder dergleichen sein. Unter elektronischen Bauelementen werden im Zusammenhang mit der vorliegenden Erfindung auch Baugruppen, wie beispielsweise Schaltnetzteile oder Funk-Sende- und Empfangsmodule für Mobilfunkkommunikation oder WLAN, Blutooth oder dergleichen verstanden, welche aufgrund ihrer Funktion elektromagnetische Störstrahlung erzeugen oder für solche empfindlich sein können und welche Bestandteil solcher elektronischer Geräte sein können.

Bei dem Verfahren gemäß der Erfindung wird eine Leiterplatte zwischen einem ersten Gehäuseteil und einem zweiten Gehäuseteil positioniert, und die beiden Gehäuseteile werden an mehreren Befestigungsstellen kraftschlüssig miteinander verbunden, wobei zwischen den Befestigungsstellen auf der Leiterplatte eine Vielzahl von Auftragsflächen ausgebildet ist, auf welchen jeweils ein Lotwerkstoff derart aufgebracht wird, dass der Lotwerkstoff die Auftragsfläche jeweils überlappt, wobei nach dem Aufbringen des Lotwerkstoffs Wärme zugeführt wird, wodurch sich der Lotwerkstoff auf der Auftragsfläche zusammenzieht und eine kuppelartige Ausbildung auf der Auftragsfläche ausbildet, wobei die Höhe der kuppelartigen Ausbildung jeweils derart angepasst ist, dass der Lotwerkstoff einen Kontaktpunkt mit einem der beiden Gehäuseteile ausbildet.

Es wird also vorgesehen, dass zwischen den Befestigungsstellen eine Vielzahl von Stellen auf der Leiterplatte ausgebildet werden, auf welchen ein Lotwerkstoff derart aufgebracht wird, dass der Lotwerkstoff an jeder aufgebrachten Stelle eine Kontaktstelle und damit eine Kontaktierung mit jeweils einem der Gehäuseteile ausbilden kann. Um eine Kontaktierung zwischen dem Lotwerkstoff und einem der Gehäuseteile sicher gewährleisten zu können, nimmt der Lotwerkstoff eine kuppelartige Ausgestaltung an, wobei die Höhe der kuppelartigen Ausgestaltung derart angepasst ist, dass ein Kontaktpunkt zwischen dem Lotwerkstoff und einem der Gehäuseteile sicher ausgebildet wird. Dafür werden zwischen den Befestigungsstellen der beiden Gehäuseteile miteinander mehrere Auftragsflächen auf der Leiterplatte ausgebildet, auf welchen wiederum der Lotwerkstoff aufgebracht wird. Der Lotwerkstoff wird dabei derart auf die Auftragsflächen aufgebracht, dass der Lotwerkstoff zunächst die Auftragsfläche überlappt, was bedeutet, dass der Lotwerkstoff über den Rand bzw. die Außenumfangsfläche der Auftragsfläche hinausragt. Es findet damit beim Aufbringen des Lotwerkstoffes eine sogenannte Überdruckung der Auftragsfläche statt. Nach dem Aufbringen des Lotwerkstoffes auf jede einzelne der Auftragsflächen wird Wärme zugeführt, so dass der auf die einzelnen Auftragsflächen aufgebrachte Lotwerkstoff aufschmilzt und dadurch fließfähig wird. Der fließfähige Lotwerkstoff zieht sich dabei zusammen, so dass sich die Umfangsfläche des Lotwerkstoffs pro Auftragsfläche reduziert. Dafür nimmt die Höhe des aufgebrachten Lotwerkstoffs zu, so dass der auf die Auftragsfläche aufgebrachte Lotwerkstoff eine kuppelartige Ausgestaltung annimmt. Die Höhe der kuppelartigen Ausgestaltung ist dabei derart bemessen, dass der Lotwerkstoff an das ihm zugewandte Gehäuseteil anstößt und damit einen Kontaktpunkt mit dem entsprechenden Gehäuseteil ausbildet. Steifigkeiten der Gehäuseteile können dabei durch die Anpassung der Höhe der kuppelartigen Ausgestaltung des Lotwerkstoffs berücksichtigt werden, so dass alle Auftragsflächen mit dem darauf aufgebrachten Lotwerkstoff mit einem der Gehäuseteile kontaktieren können. Damit wird eine sichere elektrische Kontaktierung zwischen dem Lotwerkstoff und dem jeweiligen Gehäuseteil ausgebildet, wobei dadurch über den gesamten Umfang der Gehäuseteile eine sichere Kontaktierung zwischen den Gehäuseteilen und der Leiterplatte ausgebildet werden kann, wodurch wiederum eine sichere EMV-Abschirmung bzw. Abdichtung des elektronischen Bauelements erreicht werden kann. Durch die sichere Kontaktierung des auf die Auftragsflächen aufgebrachten Lotwerkstoffs mit den Gehäuseteilen kann zudem die Anzahl der Befestigungsstellen zwischen den beiden Gehäuseteilen reduziert werden.

Die Höhe der kuppelartigen Ausbildung des Lotwerkstoffs und des damit gebildeten elektischen Kontakts auf einer Auftragsfläche mit einer bestimmten geometrischen Fläche kann somit bevorzugt dadurch eingestellt werden, dass die Menge des auf die Auftragsfläche aufgebrachten Lotwerkstoffs an die (geometrische) Fläche der Auftragsfläche angepasst wird.

Der Lotwerkstoff wird vorzugsweise mittels eines Siebes auf die Leiterplatte aufgebracht, wobei das Sieb Löcher zum Aufbringen des Lotwerkstoffs aufweist, welche jeweils einen größeren Durchmesser aufweisen als der Durchmesser der korrespondierenden Auftragsfläche. Jeder Auftragsfläche ist vorzugsweise ein Loch des Siebes zugeordnet, über welches der Lotwerkstoff auf die entsprechende Auftragsfläche aufgebracht werden kann. Dadurch, dass das jeweilige Loch einen größeren Durchmesser und damit eine größere Umfangsfläche aufweist als der Durchmesser bzw. die Außenumfangsfläche der korrespondierenden Auftragsfläche, kann der Lotwerkstoff überlappend auf die Auftragsfläche aufgebracht werden. Die Größe der einzelnen Löcher kann dabei individuell an die Größe der den Löchern jeweils zugeordneten Auftragsfläche angepasst sein. Hierdurch kann eine ausreichende Überlappung bzw. Überdruckung der Auftragsfläche mit dem aufzubringenden Lotwerkstoff sicher gewährleistet werden.

Bevorzugt kann es dabei vorgesehen sein, dass das Verhältnis zwischen dem Durchmesser eines Loches des Siebes zum Aufbringen des Lotwerkstoffs zum Durchmesser der jeweiligen Auftragsfläche mit einer Erhöhung des Abstandes der Auftragsfläche zu den Befestigungsstellen zunimmt. Die Menge des aufzubringenden Lotwerkstoffs kann sich damit vorzugsweise nach dem Abstand der entsprechenden Auftragsfläche zu den Befestigungsstellen bemessen. Bevorzugt wird am meisten Lotwerkstoff auf den Auftragsflächen aufgebracht, welche einen besonders großen Abstand zu den Befestigungsstellen aufweisen. Durch die größere Menge an aufzubringendem Lotwerkstoff kann auch die Höhe der kuppelartigen Ausbildung des Lotwerkstoffs gesteigert werden, so dass die Höhe der kuppelartigen Ausgestaltung des Lotwersktoffs bei den besonders weit entfernten Auftragsflächen zu den Befestigungsstellen besonders groß ist. Dadurch kann sichergestellt werden, dass auch an den Bereichen, welche weiter entfernt von den Befestigungsstellen ausgebildet sind und damit eine geringe Befestigungskraft zum Befestigen der beiden Gehäuseteile miteinander wirkt, eine Kontaktierung zwischen dem Lotwerkstoff und einem der Gehäuseteile im montierten Zustand des elektronischen Bauelements sicher ausgebildet werden kann.

Als Lotwerkstoff wird vorzugsweise eine Zinnlegierung verwendet. Eine Zinnlegierung zeichnet sich durch eine geringe Schmelztemperatur aus, so dass die Menge an zuzuführender Wärme reduziert werden kann. Zudem weist eine Zinnlegierung gute elektrische Kontaktierungseigenschaften auf. Es ist aber auch möglich, andere Legierungen als eine Zinnlegierung als Lotwerkstoff zu verwenden.

Die Auftragsfläche ist bevorzugt aus Kupfer ausgebildet. Durch die Verwendung von Kupfer kann eine besonders gute elektrische Leitfähigkeit zwischen der Leiterplatte und dem Lotwerkstoff ausgebildet werden.

Um eine sichere kraftschlüssige Verbindung zwischen den beiden Gehäuseteilen erreichen zu können, können die beiden Gehäuseteile an den Befestigungsstellen mittels Schrauben miteinander befestigt werden. Andere Befestigungsmittel als Schrauben sind jedoch auch denkbar, wie beispielsweise Niete.

Die Erfindung zeichnet sich ferner durch ein elektronisches Bauelement aus, welches nach einem wie vorstehend beschriebenen, aus- und weitergebildeten Verfahren hergestellt ist, wobei das elektronische Bauelement ein erstes Gehäuseteil, ein zweites Gehäuseteil und eine zwischen dem ersten Gehäuseteil und dem zweiten Gehäuseteil angeordnete Leiterplatte aufweist, wobei zwischen den Befestigungsstellen auf der Leiterplatte eine Vielzahl von Auftragsflächen ausgebildet sind, auf welchen jeweils ein Lotwerkstoff mit einer kuppelartigen Ausbildung aufgebracht ist, wobei die Höhe der kuppelartigen Ausbildung jeweils derart angepasst ist, dass der Lotwerkstoff einen Kontaktpunkt mit einem der beiden Gehäuseteile ausbildet.

Weitere, die Erfindung verbessernde Maßnahmen werden nachstehend gemeinsam mit der Beschreibung eines bevorzugten Ausführungsbeispiels der Erfindung anhand der Figuren näher dargestellt.

Es zeigen:
- Fig. 1: eine schematische Teildarstellung eines elektronsichen Bauelements gemäß der Erfindung,
- Fig. 2: eine schematische Darstellung einer Leiterplatte des in Fig. 1 gezeigten elektronischen Bauelements,
- Fig. 3: eine Detaildarstellung beim Aufbringen eines Lotwerkstoffs auf die Auftragsflächen der Leiterplatte des in Fig. 1 gezeigten elektronischen Bauelements, und
- Fig. 4: eine Detaildarstellung der kuppelartigen Ausbildung des wie in Fig. 3 gezeigten, auf die Auftragsflächen aufgebrachten Lotwerkstoffs nach Zufuhr von Wärme.

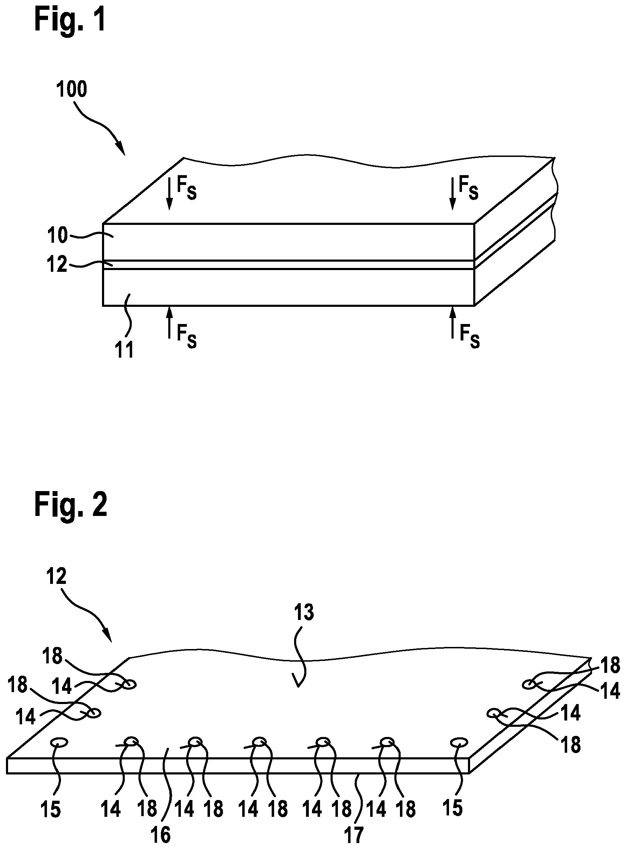

In Fig. 1 ist ein elektronisches Bauelement 100 in einem montierten Zustand gezeigt, welches ein erstes Gehäuseteil 10, ein zweites Gehäuseteil 11 und eine zwischen den beiden Gehäuseteilen 10, 11 angeordnete Leiterplatte 12 aufweist. Die beiden Gehäuseteile 10, 11 sind miteinander verbunden bzw. befestigt, wobei im Bereich der Befestigung die Klemmkräfte Fs der Befestigungsmittel, wie beispielsweise Schrauben, auf die Gehäuseteile 10, 11 und die Leiterplatte 12 wirken.

In Fig. 2 ist die Leiterplatte 12 für sich alleine dargestellt. Die Leiterplatte 12 weist auf ihrer Oberfläche 13 eine Vielzahl von Auftragsflächen 14 auf. Die Auftragsflächen 14 sind über den Rand der Leiterplatte 12 verteilt angeordnet, so dass sich die Auftragsflächen 14 zwischen den Befestigungsstellen 15, über welche die beiden Gehäuseteile 10, 11 kraftschlüssig miteinander verbunden werden, befinden. Die Befestigungsstellen 15 sind in Form von Öffnungen ausgebildet, durch welche die Befestigungsmittel, wie Schrauben, hindurchgeführt werden können. Die Auftragsflächen 14 befinden sich vorzugsweise an einer in Richtung erstem Gehäuseteil 10 zeigenden Oberseite 16 der Leiterplatte 12 und an einer in Richtung zweitem Gehäuseteil 11 zeigenden Unterseite 17 der Leiterplatte 12.

Auf jede der Auftragsflächen 14, welche hier punktförmig ausgebildet sind, wird ein Lotwerkstoff 18 aufgebracht, welcher im montierten Zustand des elektronischen Bauelements 100 eine elektrische Kontaktierung zwischen der Leiterplatte 12 und dem jeweiligen Gehäuseteil 10, 11 ausbildet.

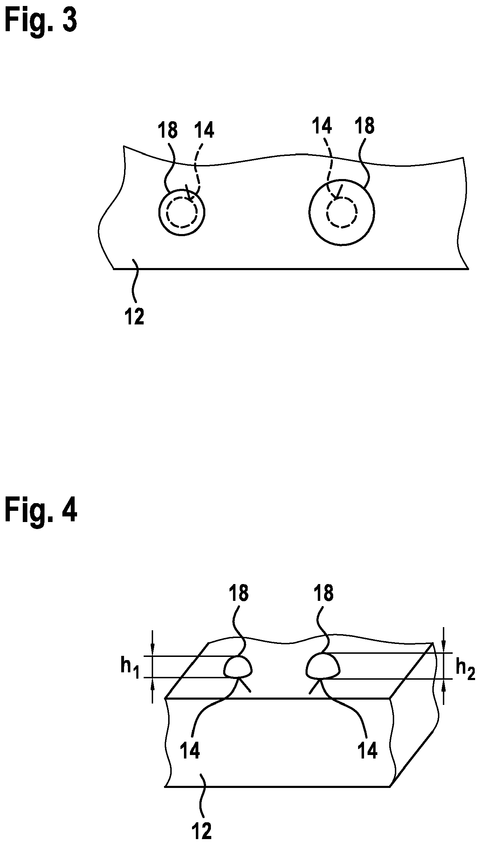

Wie in Fig. 3 gezeigt ist, wird der Lotwerkstoff 18 derart auf die Auftragsfläche 14, hier gestrichelt dargestellt, aufgebracht, dass der Lotwerkstoff 18 die Auftragsfläche 14 überlappt. Die Stärke der Überlappung kann dabei unterschiedlich stark ausgebildet sein, wie in Fig. 3 zu erkennen ist. Insbesondere die weiter von den Befestigungsstellen 15 angeordneten Auftragsflächen 14 weisen eine größere Überlappung an Lotwerkstoff 18 auf als die näher an den Befestigungsstellen 15 angeordneten Auftragsflächen 14.

Zur Ausbildung der Überlappung werden die Auftragsflächen 14 mit dem Lotwerkstoff 18 überdruckt, wobei die Stärke der Überdruckung entsprechend individuell anpassbar ist. Der Lotwerkstoff 18 wird dabei mittels eines Siebes auf die Leiterplatte 12 aufgebracht, wobei das Sieb für jede Auftragsfläche ein Loch aufweist zum Aufbringen des Lotwerkstoffs 18 auf die jeweilige Auftragsfläche 14, wobei die Löcher jeweils einen größeren Durchmesser aufweisen als der Durchmesser der Auftragsflächen 14.

Als Lotwerkstoff 18 kann eine Zinnlegierung verwendet werden. Die Auftragsflächen 14 sind aus Kupfer ausgebildet.

Nach dem Aufbringen des Lotwerkstoffs 18 wird Wärme zugeführt, wodurch der Lotwerkstoff 18 aufschmilzt und sich zusammenzieht, so dass der auf die Auftragsflächen 14 aufgebrachte Lotwerkstoff 18 eine kuppelartige Ausbildung annimmt, wie in Fig. 4 gezeigt ist.

Wie in Fig. 4 gezeigt ist, kann die Höhe h₁, h₂ der kuppelartigen Ausbildung des Lotwerkstoffs 18 an jeder Auftragsfläche 14 unterschiedlich hoch sein. Dort, wo der Lotwerkstoff 18 weniger stark überlappend auf die Auftragsfläche 14 aufgebracht worden ist, weist der Lotwerkstoff 18 nach der Wärmezufuhr eine geringere Höhe h₁ auf als dort, wo der Lotwerkstoff 18 stärker überlappend auf die Auftragsfläche 14 aufgebracht worden ist, siehe Höhe h₂. Die Höhe h₁, h₂ der kuppelartigen Ausbildung des Lotwerkstoffs 18 kann damit individuell angepasst werden, so dass sichergestellt werden kann, dass auch an den Bereichen, welche weiter entfernt von den Befestigungsstellen 15 ausgebildet sind und an welchen damit eine geringe Befestigungskraft Fs zum Befestigen der beiden Gehäuseteile 10, 11 miteinander wirkt, eine Kontaktierung zwischen dem Lotwerkstoff 18 und einem der Gehäuseteile 10, 11 sicher ausgebildet werden kann. Dadurch kann sichergestellt werden, dass der kuppelartig ausgebildete Lotwerkstoff 18 an allen über die Leiterplatte 12 verteilt angeordneten Positionen bzw. Auftragsflächen 14 einen Kontaktpunkt mit einem der Gehäuseteile 10, 11 ausbildet, so dass eine sichere EMV-Abschirmung bzw. EMV-Abdichtung des elektronischen Bauelements 100 erreicht werden kann.

Die Erfindung beschränkt sich in ihrer Ausführung nicht auf das vorstehend angegebene bevorzugte Ausführungsbeispiel. Vielmehr ist eine Anzahl von Varianten denkbar, welche von den dargestellten Lösungen auch bei grundsätzlich anders gearteten Ausführungen Gebrauch macht. Sämtliche aus den Ansprüchen, der Beschreibung oder den Zeichnungen hervorgehenden Merkmale und/oder Vorteile, einschließlich konstruktiven Einzelheiten, räumliche Anordnungen und Verfahrensschritte, können sowohl für sich als auch in den verschiedensten Kombinationen erfindungswesentlich sein.

## Patentansprüche

1. Verfahren zur Herstellung eines elektronischen Bauelements (100), bei welchem eine Leiterplatte (12) zwischen einem ersten Gehäuseteil (10) und einem zweiten Gehäuseteil (11) positioniert wird und die beiden Gehäuseteile (10, 11) an mehreren Befestigungsstellen (15) kraftschlüssig miteinander verbunden werden, wobei zwischen den Befestigungsstellen (15) auf der Leiterplatte (12) eine Vielzahl von Auftragsflächen (14) ausgebildet sind, auf welchen jeweils ein Lotwerkstoff (18) derart aufgebracht wird, dass der Lotwerkstoff (18) die Auftragsfläche (14) jeweils überlappt, wobei nach dem Aufbringen des Lotwerkstoffs (18) Wärme zugeführt wird, wodurch sich der Lotwerkstoff (18) auf der Auftragsfläche (14) zusammenzieht und eine kuppelartige Ausbildung auf der Auftragsfläche (14) ausbildet, wobei die Höhe (h₁, h₂) der kuppelartigen Ausbildung jeweils derart angepasst ist, dass der Lotwerkstoff (18) einen Kontaktpunkt mit einem der beiden Gehäuseteile (10, 11) ausbildet.

2. Verfahren nach Anspruch 1, **dadurch gekennzeichnet, dass** die Höhe (h1, h2) der jeweiligen kuppelartigen Ausbildung durch Anpassen der Menge des auf die jeweilige Auftragsfläche (14) aufgebrachten Lotwerkstoffs an die jeweilige Fläche der jeweiligen Auftragsfläche (14) eingestellt wird.

3. Verfahren nach Anspruch 1 oder 2, **dadurch gekennzeichnet, dass** der Lotwerkstoff (18) mittels eines Siebes auf die Leiterplatte (12) aufgebracht wird, welches Löcher zum Aufbringen des Lotwerkstoffes (18) aufweist, welche einen größeren Durchmesser aufweisen als der Durchmesser der jeweiligen Auftragsfläche (14).

4. Verfahren nach Anspruch 3, **dadurch gekennzeichnet, dass** das Verhältnis zwischen dem Durchmesser eines Loches des Siebes zum Aufbringen des Lotwerkstoffs (18) zum Durchmesser der jeweiligen Auftragsfläche (14) mit einer Erhöhung des Abstandes der Auftragsfläche (14) zu den Befestigungsstellen (15) zunimmt.

5. Verfahren nach einem der Ansprüche 1 bis 4, **dadurch gekennzeichnet, dass** als Lotwerkstoff (18) eine Zinnlegierung verwendet wird.

6. Verfahren nach einem der Ansprüche 1 bis 5, **dadurch gekennzeichnet, dass** die Auftragsflächen (14) aus Kupfer ausgebildet werden.

7. Verfahren nach einem der Ansprüche 1 bis 6, **dadurch gekennzeichnet, dass** die beiden Gehäuseteile (10, 11) an den Befestigungsstellen (15) mittels Schrauben miteinander befestigt werden.

8. Elektronisches Bauelement (100) hergestellt nach einem Verfahren nach einem der Ansprüche 1 bis 7, mit einem ersten Gehäuseteil (10), einem zweiten Gehäuseteil (11) und einer zwischen dem ersten Gehäuseteil (10) und dem zweiten Gehäuseteil (11) angeordneten Leiterplatte (12), wobei zwischen den Befestigungsstellen (15) auf der Leiterplatte (12) eine Vielzahl von Auftragsflächen (14) ausgebildet sind, auf welchen jeweils ein Lotwerkstoff (18) mit einer kuppelartigen Ausbildung aufgebracht ist, wobei die Höhe der kuppelartigen Ausbildung jeweils derart angepasst ist, dass der Lotwerkstoff (18) einen Kontaktpunkt mit einem der beiden Gehäuseteile (10, 11) ausbildet.
